# EUROPÄISCHE PATENTANMELDUNG

(11) **EP 4 839 075 A1**
(43) Veröffentlichungstag der Anmeldung: **11.11.2026**
(21) Anmeldenummer: 26177562.1
(22) Anmeldetag: 08.05.2026
(51) Int. Cl.: H10W 40/25, C04B 37/00, H05K 1/03, H10W 40/22, H10W 40/47

(54) **LEISTUNGSMODUL MIT TURBULENZBLECH**

(30) Priorität: 08.05.2025 DE 102025117800
(71) Anmelder: Volkswagen Aktiengesellschaft, 38440 Wolfsburg (DE)
(72) Erfinder: Wilke, Robert, 38440 Wolfsburg (DE); Lieker, Stephan, 38440 Wolfsburg (DE); Bayer, Christoph Friedrich, 38440 Wolfsburg (DE)
(74) Vertreter: Patentanwälte Bressel und Partner mbB

(57) **Zusammenfassung**

Leistungsmodul (1; 10), aufweisend
- einen Schaltungsträger (2) aus Keramik, der auf einer Oberseite eine erste obere Metallisierungsschicht (3) aufweist,
- ein auf einer Unterseite des Schaltungsträgers (2) befestigtes Turbulenzblech (4), das von der Unterseite aus nach unten weisende Erhebungen (5) aufweist.

## Beschreibung

Die Erfindung betrifft ein Leistungsmodul mit verbesserter Wärmeableitung und Verfahren zu dessen Herstellung.

Bekannte Leistungsmodule, beispielsweise für Wechselrichter, weisen einen Schaltungsträger aus Keramik auf, der eine obere und eine untere Metallisierungsschicht aufweist. Auf der oberen Metallisierungsschicht sind unter anderem Leistungshalbleiter, Kontaktpins und Anschlussbleche kontaktiert. Über die untere Metallisierungsschicht, auf der Unterseite des Schaltungsträgers, die üblicherweise eine durchgängige Metallisierungsschicht ist, wird der Schaltungsträger mit einem Kühler kontaktiert, um Wärme aus dem Leistungsmodul abzuführen. Die obere und die untere Metallisierungsschicht werden üblicherweise gleich dick und gleichzeitig auf dem Schaltungsträger aus Keramik hergestellt. Durch die gleiche Dicke und den symmetrischen Aufbau werden thermische Spannungen, die zu Verbiegungen der Keramik und Rissen führen könnten, vermieden. Es wird für die obere Metallisierungsschicht eine Dicke von 300 bis 800 Mikrometer gewählt. Eine solche Dicke ist bei der unteren Schicht aber insofern nachteilig, als dass die Wärmeleitung von der Keramik an den Kühler dadurch verringert wird.

DE 10 2012 102611 A1 beschreibt eine Metallisierung mit Ausnehmungen, auf der Unterseite einer Keramikschicht. Diese wird mit einer weiteren Metallisierung verbunden. Die Metallisierungen sind randseitig miteinander verbunden, vorzugsweise flüssigkeits- oder gasdicht.

Aufgabe der Erfindung war es, ein Leistungsmodul mit einer verbesserten Wärmeableitung auf der Unterseite eines Schaltungsträgers aus Keramik bereitzustellen.

Die Erfindung betrifft ein Leistungsmodul mit verbesserter Wärmeableitung und Verfahren zu dessen Herstellung gemäß den unabhängigen Patentansprüchen. Spezielle Ausführungsformen sind in den abhängigen Ansprüchen und dieser Beschreibung angegeben.

Angegeben wird ein Leistungsmodul, aufweisend
- einen Schaltungsträger aus Keramik, der auf einer Oberseite eine erste obere Metallisierungsschicht aufweist,
- ein auf einer Unterseite des Schaltungsträgers befestigtes, vorzugsweise durch einen Umformprozess hergestelltes Turbulenzblech, das von der Unterseite aus nach unten weisende Erhebungen aufweist.

Durch das Weglassen einer unteren Metallisierungsschicht mit einer üblichen Dicke von 300 bis 800 Mikrometer und stattdessen der Verwendung eines Turbulenzbleches, das für eine turbulente Strömung eines vorbei geleiteten Kühlmediums sehr nahe der Unterseite des Schaltungsträgers sorgt, wird eine verbesserte Wärmeabfuhr erreicht.

Ferner kann ein vorgefertigtes Turbulenzblech verwendet werden, was bei der Herstellung des Leistungsmoduls sehr vorteilhaft ist.

Das Turbulenzblech ist vorzugsweise durch einen Umformprozess erhalten, beispielsweise aus einem ebenen Blech-Vorprodukt, das keine Erhebungen aufweist. Ein beispielhafter Umformprozess ist Tiefziehen. Gegenstand der Erfindung ist auch ein Leistungsmodul, bei dem das Turbulenzblech nicht durch Umformen erhalten ist.

Die Angaben "Unterseite", "Oberseite", "unten" und "oben" beziehen sich auf eine Einbaulage des Leistungsmoduls, in der eine Kühlung auf einer Unterseite des Schaltungsträgers erfolgt und auf einer Oberseite einer oder mehrere Leistungshalbleiter an die erste obere Metallisierungsschicht kontaktiert sind. Die Oberseite kann alternativ als erste Seite bezeichnet werden und die Unterseite als zweite Seite.

Das Turbulenzblech kann mindestens 30% einer unteren Oberfläche des Schaltungsträgers überdecken, vorzugsweise mindestens 50% oder 70%, mehr bevorzugt mindestens 80%.

Das Turbulenzblech kann als Profilblech ausgebildet sein. Erhebungen können beispielsweise in das Turbulenzblech eingeprägt sein oder durch Strangpressen erhalten sein.

Das Turbulenzblech ist vorzugsweise aus Aluminium oder Kupfer, oder einer Legierung mit einem dieser Metalle als Hauptbestandteil.

Die Erhebungen haben, ausgehend von einer tiefsten Stelle in dem Turbulenzblech, vorzugsweise eine Höhe von 1 bis 5 Millimeter. Eine tiefste Stelle ist eine Stelle, die auf der Unterseite des Turbulenzbleches auf der Oberfläche des Turbulenzbleches liegt.

Beispielhafte Keramiken für Schaltungsträger sind Si₃N₄/Al₂O₃ oder Zirkon-verstärktes Aluminiumoxid (ZTA)/AIN.

Die Erhebungen des Turbulenzblechs bilden vorzugsweise ein regelmäßiges Muster auf. Die Erhebungen des Turbulenzblechs sind vorzugsweise gleichartig gestaltet. Zwischen Erhebungen sind vorzugsweise Täler oder Senken ausgebildet.

**In** einer Ausführungsform weist das Leistungsmodul eine auf einer Unterseite des Schaltungsträgers befestigte Einhausung auf, durch welche ein umschlossener Raum zwischen der Unterseite und der Einhausung gebildet wird und welche das Turbulenzblech umschließt. In dieser Ausführungsform wird ein geschlossener Raum gebildet, durch den ein flüssiges Kühlmedium geströmt werden kann. Der umschlossene Raum weist vorzugsweise zumindest einen Einlass und zumindest einen Auslass für ein Kühlmedium auf. Die Einhausung kann an auf verschiedene Art an der Unterseite des Schaltungsträgers befestigt sein, z.B. durch Löten, Schweißen, Schrauben, Klemmen oder Kleben. Die Einhausung kann aus Metall oder Kunststoff sein. Die Einhausung ist vorzugsweise aus einem Material, das bis zu einer Temperatur von 125°C formstabil ist.

In einer Ausführungsform weist das Leistungsmodul eine haftvermittelnde Substanz auf, die zwischen dem Turbulenzblech und der Keramik angeordnet ist und über welche das Turbulenzblech an die Keramik angebunden ist. Die haftvermittelnde Substanz kann ein Metall sein, an welches das Turbulenzblech beispielsweise angelötet oder angeschweißt werden kann. Die Materialstärke der haftvermittelnden Substanz ist vorzugsweise maximal 200 Mikrometer, vorzugsweise maximal 150 Mikrometer, mehr bevorzugt maximal 100 Mikrometer. Eine bevorzugte Mindestdicke, die mit allen genannten Maximalwerten kombiniert werden kann, ist 10 Mikrometer.

Die haftvermittelnde Substanz kann in Form einer durchgehenden Schicht auf den Schaltungsträger aufgebracht werden oder als Schicht mit Unterbrechungen oder nur in einzelnen Bereichen auf den Schaltungsträger aufgebracht werden.

In einer Ausführungsform ist die haftvermittelnde Substanz eine durchgehende Metallisierungsschicht auf der Unterseite des Schaltungsträgers und die Metallisierungsschicht auf der Unterseite hat eine Dicke von maximal 200 Mikrometer, vorzugsweise maximal 150 Mikrometer, mehr bevorzugt maximal 100 Mikrometer. Eine bevorzugte Mindestdicke, die mit allen genannten Maximalwerten kombiniert werden kann, ist 10 Mikrometer. Die durchgehende Metallisierungsschicht kann auf einfache Weise erzeugt werden und lässt viele Möglichkeiten der Anbindung des Turbulenzblechs an verschiedenen Stellen.

In einer Ausführungsform hat die erste obere Metallisierungsschicht die gleiche Schichtdicke oder im Wesentlichen wie die durchgehende Metallisierungsschicht auf der Unterseite des Schaltungsträgers. Dies hat den Vorteil, dass genannte Metallisierungsschichten symmetrisch zu dem Schaltungsträger sind und ein thermischer Verzug des Schaltungsträgers vermieden wird, vor allem wenn die genannte Metallisierungsschichten aus einem gleichen Metall, zum Beispiel Kupfer oder Aluminium, sind.

Eine im Wesentlichen gleiche Schichtdicke bedeutet eine Abweichung von maximal 10%, vorzugsweise maximal 5% von der einer größeren Schichtdicke im Vergleich zu der geringeren Schichtdicke. Wenn also die geringere Schichtdicke beispielsweise 100 Mikrometer dick ist, dann beträgt die größere Schichtdicke maximal 110 Mikrometer, vorzugsweise maximal 105 Mikrometer.

Die erste obere Metallisierungsschicht hat vorzugsweise eine Dicke von maximal 200 Mikrometer, oder maximal 150 Mikrometer, oder maximal 100 Mikrometer. Eine bevorzugte Mindestdicke, die mit allen genannten Maximalwerten kombiniert werden kann, ist 10 Mikrometer.

In einer Ausführungsform ist die durchgehende Metallisierungsschicht auf der Unterseite des Schaltungsträgers, als Fall der haftvermittelnden Substanz, aus Kupfer oder Aluminium.

In einer Ausführungsform ist die erste obere Metallisierungsschicht aus Kupfer.

In einer speziellen Ausführungsform sind die durchgehende Metallisierungsschicht auf der Unterseite des Schaltungsträgers und die erste obere Metallisierungsschicht beide aus Kupfer. Durch die Materialgleichheit ist eine Symmetrie bezüglich des Materials herstellbar und thermischem Verzug kann entgegen gewirkt werden. Diese Ausführungsform kann vorzugsweise kombiniert werden mit einem Turbulenzblech aus Kupfer.

In einer Ausführungsform ist das Turbulenzblech aus Aluminium und die durchgehende Metallisierungsschicht auf der Unterseite des Schaltungsträgers aus Aluminium. Hierdurch ist eine Verbindung zwischen Turbulenzblech und durchgehender Metallisierungsschicht besonders gut herstellbar. Diese Ausführungsform kann vorzugsweise kombiniert werden mit einer ersten oberen Metallisierungsschicht aus Kupfer.

In einer Ausführungsform ist auf der ersten oberen Metallisierungsschicht eine zweite obere Metallisierungsschicht aufgebracht. Die zweite obere Metallisierungsschicht ist vorzugsweise dicker als die erste obere Metallisierungsschicht.

Die zweite obere Metallisierungsschicht hat vorzugsweise eine Dicke von 300 bis 2000 Mikrometer, 300 bis 1500 Mikrometer, 300 bis 1200 Mikrometer, 500 bis 2000 Mikrometer, 500 bis 1500 Mikrometer, 500 bis 1200 Mikrometer, 600 bis 2000 Mikrometer, 600 bis 1500 Mikrometer, oder 600 bis 1200 Mikrometer.

Genannte Dicken der zweiten oberen Metallisierungsschicht dienen der besseren Wärmeverteilung- und Ableitung. Erfindungsgemäß ist vorzugsweise vorgesehen, nur eine Metallisierungsschicht einer solchen Dicke aufzubringen, auf der Oberseite, und auf der Unterseite Metallschicht mit einer solchen Dicke nicht vorzusehen, wodurch sich eine erhebliche Materialeinsparung ergibt. Im Stand der Technik wird häufig bevorzugt auch auf der Unterseite eine relativ dicke Metallschicht vorgesehen um Wärme abzuleiten. Dies ist erfindungsgemäß nicht nötig, weil ein Turbulenzblech verwendet wird.

Die zweite obere Metallisierungsschicht ist vorteilhaft geeignet zur Anbindung von Schaltungskomponenten, wie beispielsweise Leistungshalbleitern, Leiterpins, Anschlussblechen, Bonddraht etc.

Die zweite obere Metallisierungsschicht dient vorzugsweise auch der Ableitung von Wärme im Betrieb, zum Beispiel von Wärme, die aus Schaltungskomponenten, insbesondere Leistungshalbleitern, erzeugt wird.

Die zweite obere Metallisierungsschicht ist vorzugsweise aus Kupfer.

In einer Ausführungsform sind die erste obere Metallisierungsschicht und die zweite obere Metallisierungsschicht aus Kupfer. Hierbei ist eine besonders gute Lotverbindung möglich.

In einer Ausführungsform ist die erste obere Metallisierungsschicht aus Kupfer und die durchgehende Metallisierungsschicht auf der Unterseite des Schaltungsträgers ist aus Aluminium. Dies ermöglicht zum einen eine gute Verbindung zwischen einer zweiten oberen Metallisierungsschicht aus Kupfer und der ersten oberen Metallisierungsschicht, und zum anderen eine gute Verbindung zwischen einem Turbulenzblech aus Aluminium mit der durchgehenden Metallisierungsschicht auf der Unterseite des Schaltungsträgers. In einer speziellen Variante ist die erste obere Metallisierungsschicht ist 1,1 bis 1,7 mal oder 1,2 bis 1,6 mal so dick wie die durchgehende Metallisierungsschicht auf der Unterseite, wodurch thermische Ausdehnungsunterschiede ausgeglichen werden können.

In einer Ausführungsform ist die zweite obere Metallisierungsschicht mittels einer Lotschicht auf die erste obere Metallisierungsschicht aufgebracht. Das Lot der Lotschicht ist bevorzugt ein Lot, das einen Schmelzpunkt im Bereich von 150 bis 260°C, 150 bis 250°C, 150 bis 240°C, 150 bis 220°C, 170 bis 260°C, 170 bis 250°C, 170 bis 240°C, 170 bis 220°C, 200 bis 260°C, 200 bis 250°C, 200 bis 240°C, oder 200 bis 220°C aufweist. Ein Schmelzpunkt in einem dieser Bereiche hat den Vorteil, dass zum einen die Anbindung der zweiten oberen Metallisierungsschicht auf die erste obere Metallisierungsschicht bei relativ milden Temperaturen erfolgen kann, was thermischen Verzug verringert und zum anderen die Lotverbindung gegenüber in die zweite obere Metallisierungsschicht eingetragene Wärme im Betrieb, zum Beispiel durch Halbleiterelemente eingetragene Wärme, widerstandsfähig ist.

In einer Ausführungsform ist die haftvermittelnde Substanz in begrenzten Flächenbereichen auf der Unterseite des Schaltungsträgers ausgebildet. Hierdurch wird der Aufwand, insbesondere Materialaufwand und Bearbeitungsaufwand zur Herstellung oder Aufbringung der haftvermittelnden Substanz reduziert.

In einer Ausführungsform ist die haftvermittelnde Substanz aus der Keramik durch Reduktion einer Metallverbindung in der Keramik zu einem elementaren Metall erhalten. Beispielhaft weist die Keramik Aluminiumoxid auf, das zu elementarem Aluminium reduziert werden kann. Eine Reduktion kann durch Lasereinwirkung erreicht werden. An das elementare Metall kann das Turbulenzblech vorzugsweise über eine Lotverbindung angebunden werden.

In einem Aspekt betrifft die Erfindung ein erstes Verfahren zur Herstellung eines Leistungsmoduls, aufweisend
a) Aufbringen einer unteren durchgehenden Metallisierungsschicht auf einer Unterseite eines Schaltungsträgers aus Keramik
b) Aufbringen einer ersten oberen Metallisierungsschicht auf einer Oberseite des Schaltungsträgers aus Keramik, welche die gleiche oder in Wesentlichen gleiche Schichtdicke hat wie die untere durchgehende Metallisierungsschicht auf der Unterseite des Schaltungsträgers,
c) Befestigen eines Turbulenzbleches auf der unteren durchgehenden Metallisierungsschicht, wobei das Turbulenzblech von der Unterseite des Schaltungsträgers aus nach unten weisende Erhebungen aufweist.

In einer Ausführungsform weist das vorangehend genannte erste Verfahren auf:
d) Aufbringen einer zweiten oberen Metallisierungsschicht auf die erste obere Metallisierungsschicht.

In einem Aspekt betrifft die Erfindung ein zweites Verfahren zur Herstellung eines Leistungsmoduls, aufweisend
i) Bereitstellen eines Schaltungsträgers aus Keramik
ii) Reduzieren einer Metallverbindung, die in der Keramik vorhanden ist, zu einem elementaren Metall in begrenzten Flächenbereichen auf einer Unterseite des Schaltungsträgers,
iii) Befestigen eines Turbulenzbleches in den Flächenbereichen auf der Unterseite des Schaltungsträgers.

Die beiden Verfahren betreffen unterschiedliche Arten und Weisen der Anbindung des Turbulenzbleches an den Schaltungsträger.

Bei beiden Verfahren können einzeln oder in Kombination die vorangehend anhand eines Leistungsmoduls beschriebenen Merkmale Anwendung finden. Vorangehend bereits genannte verfahrensartige Merkmale können in diesem Verfahren Anwendung finden. Vorangehend bereits genannte strukturelle Merkmale können in diesen Verfahren Anwendung finden.

Das erste Verfahren hat den besonderen Vorteil, dass ein thermischer Verzug verringert werden kann. In dem ersten Verfahren können die untere durchgehende Metallisierungsschicht und die erste obere Metallisierungsschicht gleichzeitig aufgebracht werden. Das zweite Verfahren hat den Vorteil eines Einsparens zusätzlichen Materials für die haftvermittelnde Substanz, die in diesem Fall aus der Keramik selbst gewonnen wird. Weitere Vorteile wurden zuvor genannt.

Die genannten Tätigkeiten müssen nicht zwingend in der aufgeführten Reihenfolge erfolgen. Andere Reihenfolgen von Tätigkeiten sind von der Erfindung umfasst.

Nachfolgend wird die Erfindung anhand von Ausführungsbeispielen beschrieben. Es zeigen:
- Fig. 1:: eine erste Ausführungsform eines erfindungsgemäßen Leistungsmoduls;
- Fig. 2:: ein Turbulenzblech in perspektivischer Ansicht;
- Fig. 3:: eine zweite Ausführungsform eines erfindungsgemäßen Leistungsmoduls;
- Fig. 4:: ein erstes erfindungsgemäßes Verfahren zur Herstellung eines erfindungsgemäßen Leistungsmoduls;
- Fig. 5:: ein zweites erfindungsgemäßes Verfahren zur Herstellung eines erfindungsgemäßen Leistungsmoduls.

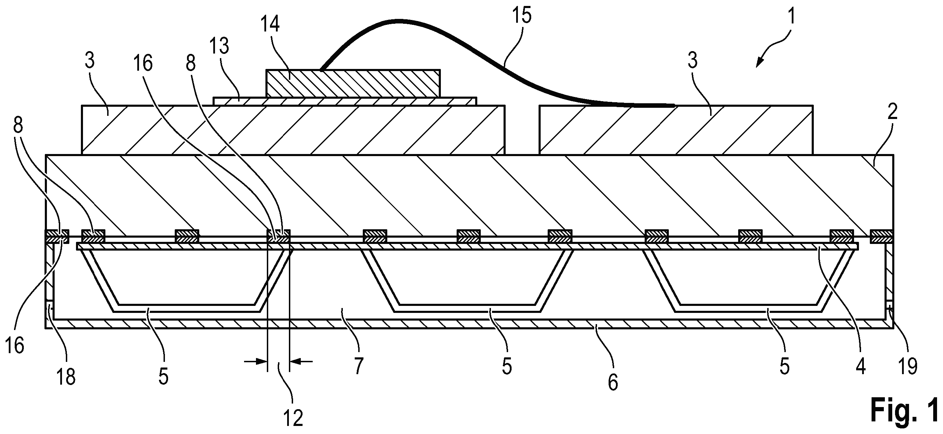

Das in Fig. 1 gezeigte Leistungsmodul 1 mit der an seiner Unterseite angebrachten Einhausung 6 weist den Schaltungsträger 2 mit der ersten oberen Metallisierungsschicht 3 auf, die eine unterbrochene Schicht ist, um getrennte Leiterbahnen auszubilden. Über die Sinterschicht 13 ist der Leistungshalbleiter 14 unterseitig auf die ersten oberen Metallisierungsschicht 3 kontaktiert. Der Leistungshalbleiter 14 ist oberseitig über Bonddraht 15 an eine weitere Leiterbahn der oberen Metallisierungsschicht 3 angebunden.

Auf der unteren Seite des Schaltungsträgers 2 ist das Turbulenzblech 4 angebunden. **In** den Flächenbereich 12 ist ein in dem Schaltungsträger 2 enthaltenes Aluminiumoxid mittels Laserbehandlung und Reduktionmittel zu Aluminium reduziert worden. Das in den Flächenbereichen 12 gebildete Aluminium bildet die haftvermittelnde Substanz 8, auf welche das Turbulenzblech 4 mittels der Lots 16 angebunden ist. Unterseitig weist das Turbulenzblech 4 die Erhebungen 5 auf.

Die an dem Leistungsmodul an seiner Unterseite angebrachte Einhausung 6 ist ebenfalls über ein Lot 16 an den Schaltungsträger 2 angebunden und es ist ein umschlossener Raum 7 zwischen der Unterseite des Leitungsmoduls 1 und der Einhausung 6 gebildet, wobei die Einhausung 6 das Turbulenzblech 4 umschließt. Der umschlossene Raum 7 weist einen Einlass 18 und einen Auslass 19 für ein Kühlmedium auf, das den umschlossenen Raum 7 durchströmen kann, wobei an den Erhebungen 5 Turbulenzen im Kühlmedium erzeugt werden.

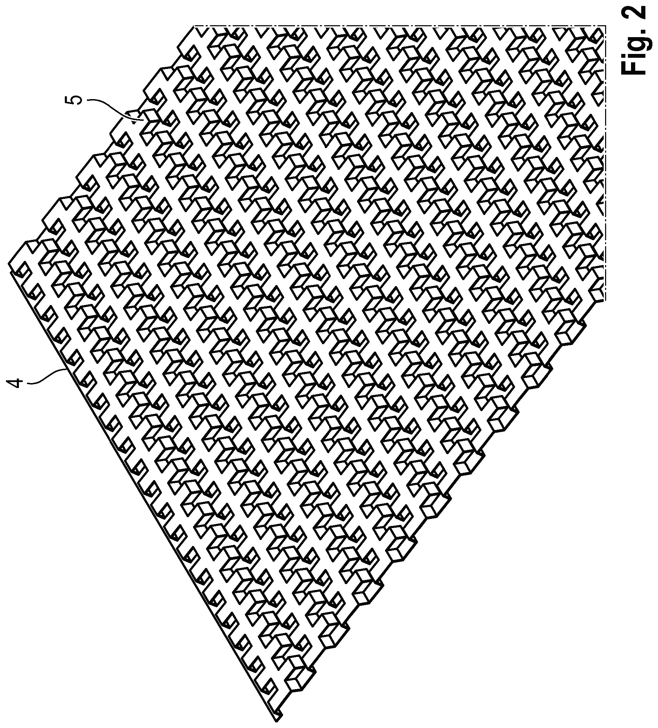

**In** Fig. 2 ist eine perspektivische Ansicht des Turbulenzblechs 4 mit dem Erhebungen 5 gezeigt, die in einem regelmäßigen Muster angeordnet sind und kleiner sind, mit mehr Erhebungen pro Fläche, als in Fig. 1 dargestellt. Ferner sind Reihen von Erhebungen zueinander versetzt, was bei dem Turbulenzblech in Fig. 1 nicht der Fall ist, sodass das Turbulenzblech 4 in Fig. 2 anders gestaltet ist als in Fig. 1 und weiteren Figuren.

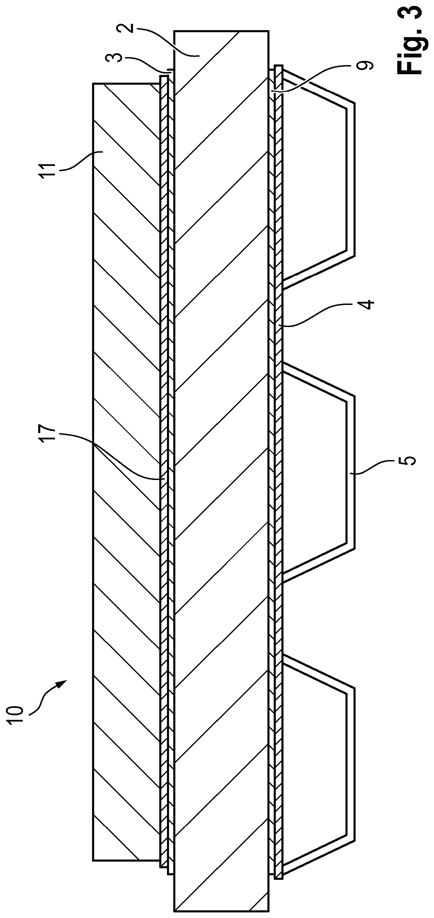

In der Ausführungsform des Leistungsmoduls 10 der Fig. 3 weist der Schaltungsträger 2 auf seiner Unterseite als haftvermittelnde Substanz 9 eine durchgängige Metallisierungsschicht auf, die in diesem Beispiel eine Dicke von 100 Mikrometer hat. Die erste obere Metallisierungsschicht 3 hat ebenfalls eine Dicke von 100 Mikrometer und ist auf der Oberseite des Schaltungsträgers 2 aufgebracht. Auf diese erste oberen Metallisierungsschicht 3 ist mittels der Lotschicht 17 die zweite obere Metallisierungsschicht 11 aufgebracht, die eine Dicke von 800 Mikrometern hat. Die erste obere Metallisierungsschicht 3 ist eine unterbrochene Schicht, um getrennte Leiterbahnen auszubilden, analog zu Fig. 1, wobei Unterbrechungen in der ersten oberen Metallisierungsschicht 3 aber in Fig. 3 nur aufgrund einer vereinfachten Darstellungsweise nicht dargestellt sind.

Die erste obere Metallisierungsschicht 3 kann mittels eines Hartlötprozesses oder Active Metal Brazing oder Direct Bonding auf den Schaltungsträger 2 aufgebracht werden. Direct bonding bietet sich besonders an, wenn der Schaltungsträger 2 aus einer Aluminiumoxidkeramik ist und die erste obere Metallisierungsschicht 3 aus Kupfer oder Aluminium ist.

Die durchgängige Metallisierungsschicht als haftvermittelnde Substanz 9 kann mittels eines Hartlötprozesses oder Active Metal Brazing oder Direct Bonding auf den Schaltungsträger 2 aufgebracht werden. Direct bonding bietet sich besonders an, wenn der Schaltungsträger 2 aus einer Aluminiumoxidkeramik ist und die durchgängige Metallisierungsschicht aus Kupfer oder Aluminium ist.

Das Turbulenzblech 4 ist auf die durchgängige Metallisierungsschicht 9 aufgelötet (ein Lot ist nicht dargestellt) oder geschweißt. Eine Einhausung 6 kann analog zu Fig. 1 kann noch angebracht werden.

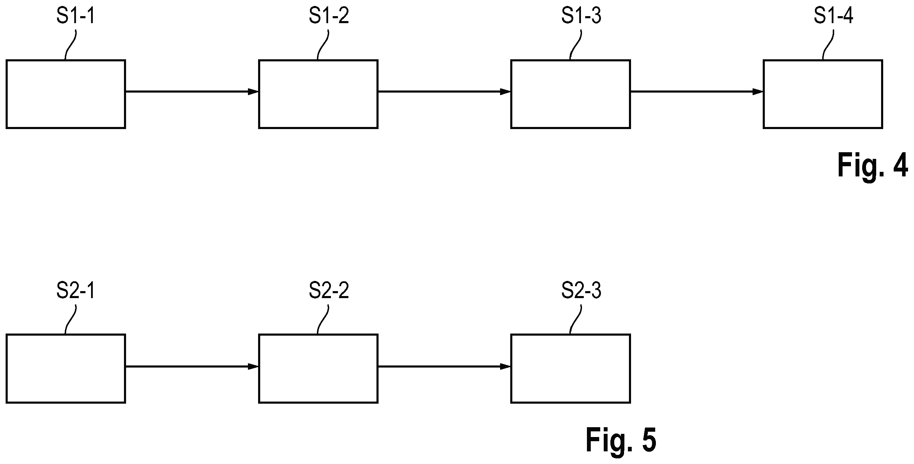

In dem in Fig. 4 schematisch dargestellten Verfahren zur Herstellung des Leistungsmoduls 10 aus Fig. 3 erfolgt in S1-1 ein Aufbringen der unteren durchgehenden Metallisierungsschicht als haftvermittelnde Substanz 9 auf der Unterseite des Schaltungsträgers 2. Davor, danach oder zeitgleich erfolgt das Aufbringen S1-2 der ersten oberen Metallisierungsschicht 3 auf der Oberseite des Schaltungsträgers 2. Anschließend erfolgt das Befestigen S1-3 des Turbulenzbleches 4 auf der unteren durchgehenden Metallisierungsschicht, mit den nach unten weisenden Erhebungen 5. Schließlich erfolgt das Aufbringen S1-4 der zweiten oberen Metallisierungsschicht 11 auf die erste obere Metallisierungsschicht 3. Die erste obere Metallisierungsschicht 3 wird als unterbrochene Schicht aufgebracht, um getrennte Leiterbahnen zu bilden. In einer Variante kann die erste obere Metallisierungsschicht 3 zunächst als durchgehende Schicht aufgebracht werden und danach können Unterbrechungen gebildet werden, beispielsweise durch Ätzen.

Die in Fig. 4 dargestellte Reihenfolge ist nicht zwingend und nur beispielhaft. Andere technisch machbare Reihenfolgen von Tätigkeiten sind von der Erfindung umfasst. Ferner ist es möglich, weitere Maßnahmen vorzusehen, wie eine Bestückung mit Komponenten, beispielsweise Halbleitern, und das Einbetten in eine Gießmasse. Ein beispielhafter alternativer Ablauf ist: S1-1, S1-2, S1-4, dann Bestückung des Schaltungsträgers mit Halbleitern, Vergießen, und dann S1-3.

In dem in Fig. 5 schematisch dargestellten Verfahren zur Herstellung des Leistungsmoduls 1 aus Fig. 1 erfolgt das Bereitstellen S2-1 des Schaltungsträgers 2 aus Keramik Anschließend erfolgt das Reduzieren S2-2 von in der Keramik vorhandenem Aluminiumoxid durch, in diesem Beispiel, Laserbehandlung und Reduktionsmittel, zu elementarem Aluminium in den begrenzten Flächenbereichen 12 auf der Unterseite des Schaltungsträgers 2, Schließlich wird in S2-3 das Turbulenzblech 4 in den Flächenbereichen 12 auf der Unterseite des Schaltungsträgers 2, in diesem Beispiel über das Lot 16, befestigt.

### Bezugszeichenliste

- 1: Leistungsmodul
- 2: Schaltungsträger
- 3: erste obere Metallisierungsschicht
- 4: Turbulenzblech
- 5: Erhebung
- 6: Einhausung
- 7: Raum
- 8: haftvermittelnde Substanz
- 9: haftvermittelnde Substanz, Metallisierungsschicht
- 10: Leistungsmodul
- 11: zweite obere Metallisierungsschicht
- 12: Flächenbereich
- 13: Sinterschicht
- 14: Leistungshalbleiter
- 15: Bonddraht
- 16: Lotpunkt
- 17: Lotschicht
- 18: Einlass
- 19: Auslass

## Patentansprüche

1. Leistungsmodul (1; 10), aufweisend
- einen Schaltungsträger (2) aus Keramik, der auf einer Oberseite eine erste obere Metallisierungsschicht (3) aufweist,
- ein auf einer Unterseite des Schaltungsträgers (2) befestigtes, durch einen Umformprozess hergestelltes Turbulenzblech (4), das von der Unterseite aus nach unten weisende Erhebungen (5) aufweist.

2. Leistungsmodul (1) nach Anspruch 1, aufweisend eine auf einer Unterseite des Schaltungsträgers (2) befestigte Einhausung (6), durch welche ein umschlossener Raum (7) zwischen der Unterseite und der Einhausung (6) gebildet wird und welche das Turbulenzblech (4) umschließt.

3. Leistungsmodul (1; 10) nach Anspruch 1 oder 2, aufweisend
eine haftvermittelnde Substanz (8; 9), die zwischen dem Turbulenzblech (4) und der Keramik angeordnet ist und über welche das Turbulenzblech (4) an die Keramik angebunden ist.

4. Leistungsmodul (10) nach Anspruch 3, wobei die haftvermittelnde Substanz (9) eine durchgehende Metallisierungsschicht auf der Unterseite des Schaltungsträgers (2) ist und diese Metallisierungsschicht eine Dicke von maximal 200 Mikrometer oder maximal 150 Mikrometer hat.

5. Leistungsmodul (10) nach Anspruch 4, wobei die erste obere Metallisierungsschicht (3) die gleiche Schichtdicke hat wie die durchgehende Metallisierungsschicht auf der Unterseite des Schaltungsträgers (2).

6. Leistungsmodul (10) nach einem der vorangehenden Ansprüche, wobei auf der ersten oberen Metallisierungsschicht (3) eine zweite obere Metallisierungsschicht (11) aufgebracht ist.

7. Leistungsmodul (10) nach Anspruch 6, wobei die zweite obere Metallisierungsschicht (11) mittels einer Lotschicht (17) auf die erste obere Metallisierungsschicht (3) aufgebracht ist.

8. Leistungsmodul (10) nach Anspruch 7, wobei die Lotschicht aus einem Lot gebildet ist, das einen Schmelzpunkt im Bereich von 150 bis 260°C aufweist.

9. Leistungsmodul (10) nach einem der Ansprüche 6 bis 8, wobei die zweite obere Metallisierungsschicht (11) eine Dicke von 300 bis 2000 Mikrometer oder 300 bis 1500 Mikrometer hat.

10. Leistungsmodul (1) nach Anspruch 3, wobei die haftvermittelnde Substanz (8) in begrenzten Flächenbereichen (12) auf der Unterseite des Schaltungsträgers (2) ausgebildet ist.

11. Leistungsmodul (1) nach Anspruch 10, wobei die haftvermittelnde Substanz (8) aus der Keramik durch Reduktion einer Metallverbindung in der Keramik zu einem elementaren Metall erhalten ist.

12. Verfahren zur Herstellung eines Leistungsmoduls (10), aufweisend
a) Aufbringen (S1-1) einer unteren durchgehenden Metallisierungsschicht als haftvermittelnde Substanz (9) auf einer Unterseite eines Schaltungsträgers (2) aus Keramik
b) Aufbringen (S1-2) einer ersten oberen Metallisierungsschicht (3) auf einer Oberseite des Schaltungsträgers (2) aus Keramik, welche die gleiche Schichtdicke hat wie die untere durchgehende Metallisierungsschicht auf der Unterseite des Schaltungsträgers (2),
c) Befestigen (S1-3) eines Turbulenzbleches (4) auf der unteren durchgehenden Metallisierungsschicht, wobei das Turbulenzblech (4) von der Unterseite des Schaltungsträgers (2) aus nach unten weisende Erhebungen (5) aufweist.

13. Verfahren nach Anspruch 12, aufweisend
d) Aufbringen (S1-4) einer zweiten oberen Metallisierungsschicht (11) auf die erste obere Metallisierungsschicht (3), vorzugsweise mittels einer Lotschicht (17).

14. Verfahren zur Herstellung eines Leistungsmoduls (1), aufweisend
i) Bereitstellen (S2-1) eines Schaltungsträgers (2) aus Keramik
ii) Reduzieren (S2-2) einer Metallverbindung, die in der Keramik vorhanden ist, zu einem elementaren Metall in begrenzten Flächenbereichen auf einer Unterseite des Schaltungsträgers (2),
iii) Befestigen (S2-3) eines Turbulenzbleches (4) in den Flächenbereichen auf der Unterseite des Schaltungsträgers (2).
